# FASCICULE DE BREVET EUROPEEN

(11) **EP 2 510 556 B1**
(45) Date de publication et mention de la délivrance du brevet: **30.03.2016**
(21) Numéro de dépôt: 10805441.2
(22) Date de dépôt: 08.12.2010
(51) Int. Cl.: H01L 31/18

(54) **PROCEDE DE TRAITEMENT THERMIQUE D'UN SUBSTRAT EN SILICIUM POUR LA FABRICATION DE CELLULES PHOTOVOLTAIQUES, ET PROCEDE DE FABRICATION DE CELLULES PHOTOVOLTAIQUES.**
VERFAHREN ZUR BEHANDLUNG EINES SILIZIUMSUBSTRATS ZUR HERSTELUNG VON PV-ZELLEN UND VERFAHREN ZUR HERSTELLUNG VON PV-ZELLEN
METHOD FOR TREATING A SILICON SUBSTRATE FOR THE PRODUCTION OF PHOTOVOLTAIC CELLS, AND PHOTOVOLTAIC CELL PRODUCTION METHOD

(30) Priorité: 10.12.2009 FR 0905971
(43) Date de publication de la demande: 17.10.2012
(73) Titulaire: Commissariat à l'Énergie Atomique et aux Énergies Alternatives, 75015 Paris (FR)
(72) Inventeur: DUBOIS, Sébastien, F-74950 Scionzier (FR); ENJALBERT, Nicolas, F-81100 Burlats (FR)
(74) Mandataire: Gevers & Orès
(86) Numéro de dépôt international: PCT/FR2010/000824
(87) Numéro de publication internationale: WO 2011/070254

(56) Documents cités:
- EP-A2- 2 107 619
- PERICHAUD I ET AL: "Limiting factors of gettering treatments in mc-Si wafers from the metallurgical route", MATERIALS SCIENCE AND ENGINEERING B, ELSEVIER SEQUOIA, LAUSANNE, CH, vol. 159-160, 15 mars 2009 (2009-03-15), pages 256-258, XP026109132, ISSN: 0921-5107, DOI: DOI:10.1016/J.MSEB.2008.11.030 [extrait le 2008-12-16]
- BINETTI S ET AL: "Study of defects and impurities in multicrystalline silicon grown from metallurgical silicon feedstock", MATERIALS SCIENCE AND ENGINEERING B, ELSEVIER SEQUOIA, LAUSANNE, CH, vol. 159-160, 15 mars 2009 (2009-03-15), pages 274-277, XP026109136, ISSN: 0921-5107, DOI: DOI:10.1016/J.MSEB.2008.05.013 [extrait le 2008-06-13]
- PERICHAUD I: "Gettering of impurities in solar silicon", SOLAR ENERGY MATERIALS AND SOLAR CELLS, ELSEVIER SCIENCE PUBLISHERS, AMSTERDAM, NL, vol. 72, no. 1-4, 1 avril 2002 (2002-04-01), pages 315-326, XP004339779, ISSN: 0927-0248, DOI: DOI:10.1016/S0927-0248(01)00179-9
- GEE J M ED - INSTITUTE OF ELECTRICAL AND ELECTRONICS ENGINEERS: "Phosphorous diffusions for gettering-induced improvement of lifetime in various silicon materials", PROCEEDINGS OF THE PHOTOVOLTAIC SPECIALISTS CONFERENCE. LAS VEGAS, OCT. 7 - 11, 1991; [PROCEEDINGS OF THE PHOTOVOLTAIC SPECIALISTS CONFERENCE], NEW YORK, IEEE, US, vol. CONF. 22, 7 octobre 1991 (1991-10-07) , pages 118-123, XP010039261, DOI: DOI:10.1109/PVSC.1991.169193 ISBN: 978-0-87942-636-1

## Description

L'invention se rapporte à un procédé de traitement d'un substrat en silicium pour la fabrication de cellules photovoltaïques contre la diminution du rendement lors de l'éclairement. L'invention concerne également un procédé de fabrication de cellules photovoltaïques à partir du substrat traité.

De nombreuses recherches visent à produire des charges de silicium à bas coût qui serviront à la croissance de lingots monocristallins et multicristallins et aux tirages de plaquettes de type ruban pour la fabrication de cellules photovoltaïques. Ces charges « bas-coûts » peuvent être produites par des purifications du silicium par voie métallurgique. II s'agit d'un procédé de purification au cours duquel le silicium ne passe jamais en phase gazeuse. La publication "Limiting factors of treatments in mc-Si wafers from the metallurgical route" par I. PERICHAUD ET AL (MATERIALS SCIENCE AND ENGINEERING B, vol. 159-160, 15 mars 2009, pages 256-258) décrit un traitement thermique appliqué à des plaquettes obtenues d'un lingot fabriqué depuis une charge purifiée par voie métallurgique.

Les charges obtenues par voie métallurgique contiennent bien souvent des teneurs en impuretés dopantes (principalement du bore et du phosphore) bien plus élevées que les charges de silicium de qualité électronique. Dans ces charges obtenues par voie métallurgique, les teneurs en bore (atome accepteur d'électrons dans le silicium) et en phosphore (atome donneur d'électrons dans le silicium) sont bien souvent du même ordre de grandeur. On parle de « charges compensées ».

Les cellules photovoltaïques fabriquées à partir de telles charges ont bien souvent un rendement de conversion énergétique qui diminue sous éclairement. Cet effet est lié à la formation, lors de l'éclairement, de complexes qui associent un atome de bore en position substitutionnelle (*Bₛ*) et un dimère d'oxygène (*0*_{*i*2}). Sous éclairement, le dimère d'oxygène (mobile) diffuse vers l'atome de bore (immobile). Le complexe formé introduit un niveau en énergie profond dans la bande interdite du silicium, qui permet la recombinaison des charges libres, et par conséquent diminue la durée de vie des porteurs de charges et le rendement de conversion énergétique de la cellule. Les effets de cette dégradation sur le rendement de conversion des cellules sont conséquents. En effet la baisse du rendement peut être voisine de 8% relatifs. Cette baisse est calculée de la manière suivante : (rendement final - rendement initial)/rendement initial.

Ainsi, il est important d'apporter des solutions capables d'atténuer, voir de supprimer les effets de cette dégradation.

L'invention a donc pour objet de proposer un procédé de fabrication de cellules photovoltaïques atténuant la dégradation du rendement lors de l'éclairement.

A cette fin, l'invention se rapporte à un procédé de traitement d'un substrat en silicium pour la fabrication de cellules photovoltaïques selon chacune des revendications indépendantes 1, 2, 3, 4 et 5.

Selon l'invention:
- le lingot en silicium présente une teneur totale en carbone comprise entre 2×10¹⁸ cm⁻³ et 10¹⁹ cm⁻³, de préférence, une teneur totale en carbone de 6,5×10¹⁸ cm⁻³;
- du carbone est introduit au cours de la fabrication du lingot.
- l'étape de recuit peut être réalisée sous air, sous flux d'azote ou sous flux de POCl₃.

L'invention se rapporte également à un procédé de fabrication de cellules photovoltaïques selon la revendication 7.

D'autres caractéristiques de l'invention seront énoncées dans la description détaillée ci-après, faite en référence aux figures annexées qui représentent, respectivement :
- la figure 1, un graphique illustrant l'évolution sous éclairement à 50°C de la tension de circuit ouvert (Voc) de cellules photovoltaïques issues de plaquettes situées à 20% de la hauteur du lingot (bas du lingot) ; et
- la figure 2, un graphique illustrant le rendement de conversion de cellules avant et après un éclairement suffisamment long pour dégrader les performances électriques des cellules et l'influence sur ce rendement du recuit à 900°C de 2 heures.

Selon l'invention, un recuit à haute température avant l'étape de formation de la jonction n/p par diffusion localisée d'éléments dopants permet de réduire, voir de supprimer, les effets de dégradation du rendement de conversion sous éclairement.

Le recuit selon l'invention consiste à chauffer le substrat en silicium à une température comprise entre 880°C et 930°C, pendant une durée comprise entre quatre et une heure. De préférence, le recuit est effectué à une température de 900°C, à ± 10°C près, pendant deux heures, à ± 10 minutes près.

Ce recuit doit être inséré avant l'étape de formation de la jonction n/p (par diffusion localisée en éléments dopants : phosphore si le substrat est de type p, ou par diffusion de bore si le substrat est de type n).

Ce recuit a un effet particulièrement positif sur le maintien du rendement de la cellule photovoltaïque si le substrat (plaquettes ou briques de silicium) contient une teneur totale en carbone (carbone dissous et carbone précipité) comprise entre 2×10¹⁸ cm⁻³ et 10¹⁹ cm⁻³ avec, de préférence, une teneur en carbone de 6,5×10¹⁸ cm⁻³.

Ces fortes teneurs en carbone peuvent être simplement liées à une contamination du silicium par le carbone induite par le procédé de purification. Le carbone peut également être introduit intentionnellement lors d'une étape préalable de fabrication du substrat (croissance des lingots).

Ainsi, conformément à l'invention, ce recuit peut être mis en place à différentes étapes lors de la fabrication d'une cellule PV :
- Dès l'étape de cristallisation, au cours du refroidissement, en insérant un palier à 900°C de 2 heures. On bénéficie alors d'un budget thermique limité, puisque lors de la cristallisation le lingot a déjà été porté à haute température. Ceci permet également de conserver des cadences de production élevées puisqu'aucune étape supplémentaire n'est nécessaire.
- Après l'étape de cristallisation, en plaçant le lingot ou les briques (les briques désignent des morceaux de lingot à partir desquels seront découpées les plaquettes pour la mise en cellule) dans une étuve à 900°C pendant 2 heures. L'avantage de cette solution est qu'elle permet de traiter simultanément des quantités importantes de silicium, et est donc facilement intégrable à une ligne de production.
- Après l'étape de sciage du lingot en plaquettes, et avant la texturation des surfaces. Cette solution est intéressante dans la mesure où l'on s'affranchit alors d'un éventuel décapage ou nettoyage chimique supplémentaire des surfaces. Par contre, l'inconvénient est que ce recuit s'effectue en présence de la couche écrouie (couche riche en défauts et impuretés créés par l'étape de sciage), à partir de laquelle des défauts et des impuretés peuvent diffuser lors du recuit et contaminer le volume des plaquettes.
- En séparant l'étape de texturation en deux étapes. Par exemple, la texturation KOH dure 40 minutes. Ainsi au bout de 20 minutes de texturation, on peut retirer les plaquettes du bain, effectuer le recuit, et à nouveau replacer les plaquettes dans le bain KOH pour la suite de la texturation (20 minutes). L'avantage de cette technique est que si le recuit s'effectue sous atmosphère oxydante, ou par exemple sous flux de POCl₃, la seconde texturation permet d'enlever un éventuel verre formé lors du recuit ou une éventuelle couche diffusée, préjudiciables pour le fonctionnement de la cellule.
- En effectuant le recuit à 900°C pendant 2 heures après la texturation, avant la formation de l'émetteur Par contre, si la surface s'oxyde, ou s'il y a formation, lors du recuit, d'une couche diffusée, il est nécessaire alors d'enlever la couche d'oxyde (trempe dans l'HF par exemple), voir de décaper la couche diffusée (solutions à base de KOH, (HF, HNO₃, H₂0), (HF, HNO₃, CH₃COOH).
- Cette étape de recuit peut enfin prendre place dans le même four que celui utilisé pour la formation de l'émetteur, en insérant avant l'étape de diffusion (phosphore ou bore), un palier à 900°C pendant 2 heures. Cette solution présente le désavantage que lors de ce palier, la surface peut facilement s'oxyder, une légère diffusion d'espèces dopantes peut également prendre place, ce qui s'avère préjudiciable à la qualité de l'émetteur formé.

De manière préférentielle, le recuit est réalisé sous flux de POCl₃. En effet, la diffusion de phosphore développe un effet getter externe (extraction et piégeage à la surface) des impuretés métalliques, qui peut ainsi améliorer les propriétés électriques du matériau, ou extraire d'éventuelles impuretés métalliques initialement précipitées, remises en solution sous l'effet des hautes températures utilisées pour le recuit.

Une étude comparative a été réalisée. Dans cette étude, ont été utilisées des plaquettes de silicium cristallisées à partir de charge purifiées par voie métallurgique. Les teneurs en bore et phosphore dans la charge (donc avant cristallisation du lingot) étaient respectivement de 1,8x10¹⁷ cm⁻³ et 4,3x10¹⁷ cm⁻³. Ces concentrations ont été mesurées par GDMS (Glow-Discharge Mass Spectrometry en anglais).

Après cristallisation, la partie du lingot utilisée est de type p.

Trois plaquettes ont été utilisées pour cette étude. Ces trois plaquettes ont été obtenues par trois sciages successifs réalisés à environ 20% de la hauteur du lingot (bas du lingot). Ainsi, les plaquettes étaient « juxtaposées » dans le lingot. En opérant de cette manière, on s'est assuré que les plaquettes présentaient des caractéristiques les plus voisines possibles.

La texturation KOH s'effectuait en 2 étapes de 2 x 20 minutes. Entre ces deux texturations, la première plaquette, dite « de référence », ne subit aucun recuit, la deuxième plaquette subit un recuit à 900°C de 2 heures sous flux d'azote, et la troisième plaquette subit le même recuit, mais sous flux de POCl₃. Le recuit est effectué dans un four à tube conventionnel. Au terme de la texturation, les plaquettes ont subi un procédé standard industriel de fabrication des cellules de type p (diffusion de phosphore en tube conventionnel pour réaliser au moins une jonction n/p, dépôt d'une couche anti-reflet SiN-H sur la face avant, dépôt des électrodes métalliques par sérigraphie, co-recuit en four à passage, ouverture de la jonction).

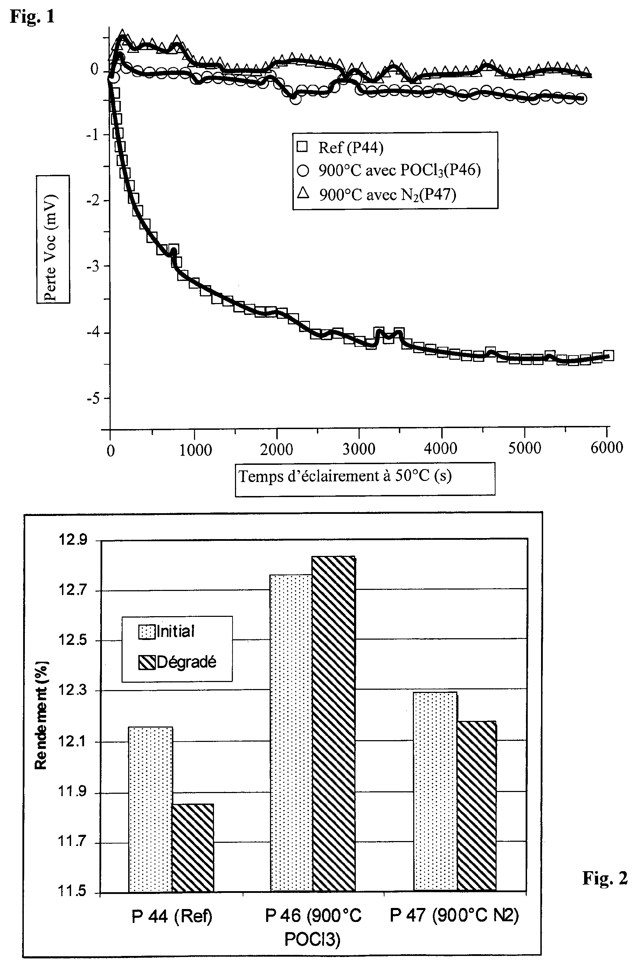

Au terme du procédé, la caractéristique courant-tension (I-V) de ces cellules a été mesurée sous éclairement. Ensuite, les cellules ont été placées sur une plaque chauffante à 50°C sous un éclairement d'1 SOLEIL (AM1.5 0.1 W.cm⁻²) et l'évolution de la tension de circuit ouvert (Voc) a été mesurée (Figure 1). A l'issue de la dégradation des propriétés électriques de ces cellules sous éclairement, les caractéristiques I-V sous éclairement des cellules étaient à nouveau mesurées, et comparées aux résultats des mesures avant dégradation (Figure 2).

La figure 1 présente l'évolution sous éclairement à 50°C du Voc de cellules issues des trois plaquettes situées à environ 20% de la hauteur du lingot. On remarque que le Voc de la cellule de référence (nayant subit aucun recuit) diminue de près de 4,5 mV sous éclairement, alors que les Voc des cellules qui ont subi le recuit restent constants. Ainsi, pour ce matériau, l'ajout de cette étape de recuit a permis d'éliminer complètement les effets de dégradation sous éclairement du rendement de conversion.

Ceci est également illustré par la figure 2 qui présente les valeurs du rendement de conversion des cellules avant et après un temps sous éclairement suffisamment long pour la formation complète des complexes BOi₂. Ce temps est aisément déterminable par un Homme de l'art.

Cette figure montre que l'étape supplémentaire de recuit n'a pas altéré les performances électriques des cellules. Au contraire, le rendement initial (histogrammes en points) des cellules qui ont subi le recuit est plus élevé. De plus, la perte sur le rendement sous éclairement pour la cellule de référence est de 2,5% relatifs, alors qu'elle est quasi-nulle pour les cellules qui ont subi le recuit (histogrammes hachurés).

L'étude expérimentale précédente a été réitérée sur d'autres matériaux, à divers degrés de compensation. La plupart de ces matériaux étaient du silicium compensé purifié par voie métallurgique, mais l'étude a également été transposée à des siliciums purifiés par voie chimique, non compensés. Toutes les plaquettes de silicium utilisées étaient des plaquettes multicristallines.

Pour le silicium multicristallin, une température de 900°C est la plus propice au recuit, car au-delà, le matériau est thermiquement instable (dissolution de précipités métalliques, propagation de dislocations...). Néanmoins, le recuit peut être effectué pour ce matériau jusqu'à 930°C, particulièrement lorsque celui-ci s'effectue sous POCl₃, la mise en solution d'impuretés métalliques étant alors contrebalancée par l'effet getter externe développé par la diffusion phosphore. A 930°C, une durée de recuit d'1 heure est suffisante pour l'obtention d'effets équivalents à un recuit de 2h à 900°C. Pour la température la plus basse, un recuit à une température de 880°C est envisageable. Par contre, la durée du recuit devra alors être multipliée par deux (4 heures de recuit), ce qui peut poser des problèmes pour une intégration industrielle du recuit.

Ensuite, on réalise les cellules photovoltaïques de manière conventionnelle à partir du substrat obtenu selon l'invention.

## Revendications

1. Procédé de traitement d'un lingot de silicium pour la fabrication de cellules photovoltaïques comprenant les étapes suivantes :
- fournir une charge purifiée par voie métallurgique;
- cristalliser la charge pour obtenir un lingot en silicium, le lingot en silicium présentant une teneur totale en carbone comprise entre 2×10¹⁸ cm⁻³ et 10¹⁹ cm⁻³, de préférence, une teneur totale en carbone de 6,5x10¹⁸ cm⁻³, du carbone étant introduit au cours de la fabrication du lingot;
- au cours de la cristallisation, recuire le lingot en silicium en le chauffant à une température comprise entre 880°C et 930°C, pendant une durée comprise entre quatre et une heure, de préférence à une température de 900°C, à ± 10°C près, pendant deux heures, à ± 10 minutes près.

2. Procédé de traitement d'un lingot de silicium pour la fabrication de cellules photovoltaïques, comprenant les étapes suivantes :
- fournir une charge purifiée par voie métallurgique;
- cristalliser la charge pour obtenir un lingot en silicium, le lingot en silicium présentant une teneur totale en carbone comprise entre 2x10¹⁸ cm⁻³ et 10¹⁹ cm⁻³, de préférence, une teneur totale en carbone de 6,5x10¹⁸ cm⁻³, du carbone étant introduit au cours de la fabrication du lingot;
- après cristallisation, recuire au moins une partie du lingot obtenu en le chauffant à une température comprise entre 880°C et 930°C, pendant une durée comprise entre quatre et une heure, de préférence à une température de 900°C, à ± 10°C près, pendant deux heures, à ± 10 minutes près.

3. Procédé de traitement de plaquettes de silicium pour la fabrication de cellules photovoltaïques, comprenant les étapes suivantes :
- fournir une charge purifiée par voie métallurgique;
- cristalliser la charge pour obtenir un lingot en silicium, le lingot en silicium présentant une teneur totale en carbone comprise entre 2×10¹⁸ cm⁻³ et 10¹⁹ cm⁻³, de préférence, une teneur totale en carbone de 6,5×10¹⁸ cm⁻³, du carbone étant introduit au cours de la fabrication du lingot;
- scier en plaquettes le lingot obtenu;
- avant texturation des surfaces des plaquettes, recuire les plaquettes en les chauffant à une température comprise entre 880°C et 930°C, pendant une durée comprise entre quatre et une heure, de préférence à une température de 900°C, à ± 10°C près, pendant deux heures, à ± 10 minutes près ;
- effectuer une étape de décapage des surfaces des plaquettes obtenues à l'étape précédente ;
- effectuer une texturation des surfaces des plaquettes.

4. Procédé de traitement de plaquettes de silicium pour la fabrication de cellules photovoltaïques, comprenant les étapes suivantes :
- fournir une charge purifiée par voie métallurgique;
- cristalliser la charge pour obtenir un lingot en silicium, le lingot en silicium présentant une teneur totale en carbone comprise entre 2×10¹⁸ cm⁻³ et 10¹⁹ cm⁻³, de préférence, une teneur totale en carbone de 6,5×10¹⁸ cm⁻³,du carbone étant introduit au cours de la fabrication du lingot;
- scier en plaquettes le lingot obtenu ;
- effectuer une texturation des surfaces des plaquettes ;
- après texturation des surfaces des plaquettes, recuire les plaquettes en les chauffant à une température comprise entre 880°C et 930°C, pendant une durée comprise entre quatre et une heure, de préférence à une température de 900°C, à ± 10°C près, pendant deux heures, à ± 10 minutes près ;
- effectuer une étape de décapage des surfaces des plaquettes obtenues à l'étape précédente.

5. Procédé de traitement de plaquettes de silicium pour la fabrication de cellules photovoltaïques, comprenant les étapes suivantes :
- fournir une charge purifiée par voie métallurgique;
- cristalliser la charge pour obtenir un lingot en silicium, le lingot en silicium présentant une teneur totale en carbone comprise entre 2×10¹⁸ cm⁻³ et 10¹⁹ cm⁻³, de préférence, une teneur totale en carbone de 6,5×10¹⁸ cm⁻³,du carbone étant introduit au cours de la fabrication du lingot;
- scier en plaquettes le lingot obtenu;
- effectuer une texturation des surfaces des plaquettes en deux étapes, entre lesquelles on recuit les plaquettes en les chauffant à une température comprise entre 880°C et 930°C, pendant une durée comprise entre quatre et une heure, de préférence à une température de 900°C, à ± 10°C près, pendant deux heures, à ± 10 minutes près.

6. Procédé de traitement selon l'une des revendications précédentes, dans lequel l'étape de recuit est réalisée sous air, sous flux d'azote ou sous flux de POCl₃.

7. Procédé de fabrication de cellules photovoltaïques comprenant les étapes suivantes :
- traiter un lingot en silicium conformément au procédé selon l'une quelconque des revendications 1 à 2 et 6 et scier en plaquettes le lingot obtenu ou traiter des plaquettes en silicium conformément au procédé selon l'une quelconque des revendications 3 à 6;
- puis réaliser les cellules photovoltaïques à partir d'une des plaquettes obtenues en enrichissant localement cette plaquette obtenue ou une partie de cette plaquette obtenue, en éléments dopants pour réaliser une jonction n/p.

## Patentansprüche

1. Verfahren zur Behandlung eines Siliziumblocks für die Herstellung von PV-Zellen, das die folgenden Schritte umfasst:
- metallurgisches Bereitstellen einer gereinigten Charge;
- Kristallisieren der Charge zum Erhalten eines Siliziumblocks, wobei der Siliziumblock einen Gesamtgehalt an Kohlenstoff, der zwischen 2×10¹⁸ cm⁻³ und 10¹⁹ cm⁻³ enthalten ist, vorzugsweise einen Gesamtgehalt an Kohlenstoff von 6,5×10¹⁸ cm⁻³, aufweist, wobei Kohlenstoff während der Herstellung des Blocks zugeführt wird;
- während der Kristallisation, Glühen des Siliziumblocks, indem er auf eine Temperatur erhitzt wird, die zwischen 880 °C und 930 °C enthalten ist, während einer Dauer, die zwischen vier und einer Stunde enthalten ist, vorzugsweise bei einer Temperatur von 900 °C ± 10 °C während zwei Stunden ± 10 Minuten.

2. Verfahren zur Behandlung eines Siliziumblocks für die Herstellung von PV-Zellen, das die folgenden Schritte umfasst:
- metallurgisches Bereitstellen einer gereinigten Charge;
- Kristallisieren der Charge zum Erhalten eines Siliziumblocks, wobei der Siliziumblock einen Gesamtgehalt an Kohlenstoff, der zwischen 2x10¹⁸ cm⁻³ und 10¹⁹ cm⁻³ enthalten ist, vorzugsweise einen Gesamtgehalt an Kohlenstoff von 6,5×10¹⁸ cm⁻³, aufweist, wobei Kohlenstoff während der Herstellung des Blocks zugeführt wird;
- nach der Kristallisation, Glühen von zumindest einem Teil des Blocks, das durch sein Erhitzen auf eine Temperatur erhalten wird, die zwischen 880 °C und 930 °C enthalten ist, während einer Dauer, die zwischen vier und einer Stunde enthalten ist, vorzugsweise bei einer Temperatur von 900 °C ± 10 °C während zwei Stunden ± 10 Minuten.

3. Verfahren zur Behandlung von Siliziumwafern zur Herstellung von PV-Zellen, das die folgenden Schritte umfasst:
- metallurgisches Bereitstellen einer gereinigten Charge;
- Kristallisieren der Charge zum Erhalten eines Siliziumblocks, wobei der Siliziumblock einen Gesamtgehalt an Kohlenstoff, der zwischen 2x10¹⁸ cm⁻³ und 10¹⁹ cm⁻³ enthalten ist, vorzugsweise einen Gesamtgehalt an Kohlenstoff von 6,5×10¹⁸ cm⁻³, aufweist, wobei Kohlenstoff während der Herstellung des Blocks zugeführt wird;
- Sägen des erhaltenen Blocks in Wafer;
- vor der Texturierung der Flächen der Wafer, Glühen der Wafer durch ihr Erhitzen auf eine Temperatur, die zwischen 880 °C und 930 °C enthalten ist, während einer Dauer, die zwischen vier und einer Stunde enthalten ist, vorzugsweise bei einer Temperatur von 900 °C ± 10 °C während zwei Stunden ± 10 Minuten;
- Durchführen eines Schritts zum Beizen der Flächen der im vorhergehenden Schritt erhaltenen Wafer;
- Durchführen einer Texturierung der Fläche der Wafer.

4. Verfahren zur Behandlung von Siliziumwafern zur Herstellung von PV-Zellen, das die folgenden Schritte umfasst:
- metallurgisches Bereitstellen einer gereinigten Charge;
- Kristallisieren der Charge zum Erhalten eines Siliziumblocks, wobei der Siliziumblock einen Gesamtgehalt an Kohlenstoff, der zwischen 2×10¹⁸ cm⁻³ und 10¹⁹ cm⁻³ enthalten ist, vorzugsweise einen Gesamtgehalt an Kohlenstoff von 6,5×10¹⁸ cm⁻³, aufweist, wobei Kohlenstoff während der Herstellung des Blocks zugeführt wird;
- Sägen des erhaltenen Blocks in Wafer;
- Durchführen einer Texturierung der Flächen der Wafer;
- nach der Texturierung der Flächen der Wafer, Glühen der Wafer durch ihr Erhitzen auf eine Temperatur, die zwischen 880 °C und 930 °C enthalten ist, während einer Dauer, die zwischen vier und einer Stunde enthalten ist, vorzugsweise bei einer Temperatur von 900 °C ± 10 °C während zwei Stunden ± 10 Minuten;
- Durchführen eines Schritts zum Beizen der Flächen der im vorhergehenden Schritt erhaltenen Wafer.

5. Verfahren zur Behandlung von Siliziumwafern für die Herstellung von PV-Zellen, das die folgenden Schritte umfasst:
- metallurgisches Bereitstellen einer gereinigten Charge;
- Kristallisieren der Charge zum Erhalten eines Siliziumblocks, wobei der Siliziumblock einen Gesamtgehalt an Kohlenstoff, der zwischen 2x10¹⁸ cm⁻³ und 10¹⁹ cm⁻³ enthalten ist, vorzugsweise einen Gesamtgehalt an Kohlenstoff von 6,5×10¹⁸ cm⁻³, aufweist, wobei Kohlenstoff während der Herstellung des Blocks zugeführt wird;
- Sägen des erhaltenen Blocks in Wafer;
- Durchführen einer Texturierung der Flächen der Wafer in zwei Schritten, zwischen denen die Wafer durch ihr Erhitzen auf eine Temperatur geglüht werden, die zwischen 880 °C und 930 °C enthalten ist, während einer Dauer, die zwischen vier und einer Stunde enthalten ist, vorzugsweise bei einer Temperatur von 900 °C ± 10 °C während zwei Stunden ± 10 Minuten.

6. Behandlungsverfahren nach einem der vorhergehenden Ansprüche, wobei der Schritt des Glühens in Luft, im Stickstoffstrom oder im POCl₃-Strom ausgeführt wird.

7. Verfahren zur Herstellung von PV-Zellen, das die folgenden Schritte umfasst:
- Behandeln eines Siliziumblocks gemäß dem Verfahren nach einem der Ansprüche 1 bis 2 und 6 und Sägen des erhaltenen Blocks in Wafer oder Behandeln der Siliziumwafer gemäß dem Verfahren nach einem der Ansprüche 3 bis 6;
- dann Ausführen der PV-Zellen ausgehend von einem der erhaltenen Wafer durch lokales Anreichern dieses erhaltenen Wafers oder eines Teils dieses erhaltenen Wafers mit Dotierelementen zum Ausführen eines n/p-Übergangs.

## Claims

1. A method for treating a silicon ingot for manufacturing photovoltaic cells comprising the following steps:
- providing a load purified via a metallurgical route;
- crystallizing the load in order to obtain a silicon ingot, the silicon ingot having a total carbon content comprised between 2.10¹⁸ cm⁻³ and 10¹⁹ cm⁻³, preferably a total carbon content of 6.5 10¹⁸ cm⁻³, carbon being introduced during the manufacturing of the ingot;
- during crystallization, annealing the silicon ingot by heating it to a temperature comprised between 880°C and 930°C, for a period comprised between four and one hour, preferably to a temperature of 900°C, to within ±10°C, for two hours, to within ±10 minutes.

2. A method for treating a silicon ingot for manufacturing photovoltaic cells comprising the following steps:
- providing a load purified via a metallurgical route;
- crystallizing the load in order to obtain a silicon ingot, the silicon ingot having a total carbon content comprised between 2.10¹⁸ cm⁻³ and 10¹⁹ cm⁻³, preferably a total carbon content of 6.5 10¹⁸ cm⁻³, carbon being introduced during the manufacturing of the ingot;
- after crystallization, annealing at least one portion of the obtained ingot by heating it to a temperature comprised between 880°C and at 930°C, for a period comprised between four and one hour, preferably to a temperature of 900°C, to within ±10°C, for two hours, to within ±10 minutes.

3. A method for treating silicon wafers for manufacturing photovoltaic cells, comprising the following steps:
- providing a load purified via a metallurgical route;
- crystallizing the load in order to obtain a silicon ingot, the silicon ingot having a total carbon content comprised between 2.10¹⁸ cm⁻³ and 10¹⁹ cm⁻³, preferably a total carbon content of 6.5 10¹⁸ cm⁻³, carbon being introduced during the manufacturing of the ingot;
- sawing the obtained ingot into wafers;
- before texturation of the surfaces of the wafers, annealing the wafers by heating them to a temperature comprised between 880°C and 930°C, for a period comprised between four and one hour, preferably at a temperature of 900°C, to within ±10°C, for two hours, to within ±10 minutes;
- carrying out a step for stripping the surfaces of the wafers obtained in the preceding step;
- carrying out texturation of the surfaces of the wafers.

4. A method for treating silicon wafers for manufacturing photovoltaic cells, comprising the following steps:
- providing a load purified via a metallurgical route;
- crystallizing the load in order to obtain a silicon ingot, the silicon ingot having a total carbon content comprised between 2.10¹⁸ cm⁻³ and 10¹⁹ cm⁻³, preferably a total carbon content of 6.5 10¹⁸ cm⁻³, carbon being introduced during the manufacturing of the ingot;
- sawing the obtained ingot into wafers;
- carrying out texturation of the surfaces of the wafers;
- after texturation of the surfaces of the wafers, annealing the wafers by heating them to a temperature comprised between 880°C and 930°C, for a period comprised between four and one hour, preferably to a temperature of 900°C, to within ±10°C, for two hours, to within ±10 minutes;
- carrying out a step for stripping the surfaces of the wafers obtained in the preceding step.

5. A method for treating silicon wafers for manufacturing photovoltaic cells, comprising the following steps:
- providing a load purified via a metallurgical route;
- crystallizing the load in order to obtain a silicon ingot, the silicon ingot having a total carbon content comprised between 2.10¹⁸ cm⁻³ and 10¹⁹ cm⁻³, preferably a total carbon content of 6.5 10¹⁸ cm⁻³, carbon being introduced during the manufacturing of the ingot;
- sawing the obtained ingot into wafers;
- carrying out texturation of the surfaces of the wafers in two steps, between which the wafers are annealed by heating them to a temperature comprised between 880°C and 930°C, for a period comprised between four and one hour, preferably to a temperature of 900°C, to within ±10°C, for two hours, to within ±10 minutes.

6. The treatment method according to one of the preceding claims, wherein the annealing step is carried out in an hour, under a nitrogen flow or under a POCl₃ flow.

7. A method for manufacturing photovoltaic cells comprising the following steps:
- treating a silicon ingot in accordance with the method according to claims 1 to 2 and 6 and sawing the obtained ingot into wafers or treating the silicone wafers in accordance with the method according to any of claims 3 to 6;
- and then producing photovoltaic cells from one of the obtained wafers by locally enriching this obtained wafer or a portion of this obtained wafer in dopant elements in order to produce a n/p junction.
